(19) **Europäisches Patentamt / European Patent Office / Office européen des brevets**

(11) **EP 4 095 537 B1**

(12) **EUROPEAN PATENT SPECIFICATION**

(45) Date of publication and mention
of the grant of the patent:
**06.09.2023  Bulletin 2023/36**

(21) Application number: **22173334.8**

(22) Date of filing: **13.05.2022**

(51) International Patent Classification (IPC):
**G01R 31/392** *(2019.01)*     **G01R 31/367** *(2019.01)*

(52) Cooperative Patent Classification (CPC):
**G01R 31/392; G01R 31/367**

(54) **NEURAL NETWORK FOR ESTIMATING BATTERY HEALTH**

NEURONALES NETZWERK ZUR EINSCHÄTZUNG DES BATTERIEZUSTANDS

RÉSEAU DE NEURONES ARTIFICIELS POUR ESTIMER L'ÉTAT D'UNE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.05.2021  US 202163192352 P**
**22.12.2021  US 202117558820**

(43) Date of publication of application:
**30.11.2022  Bulletin 2022/48**

(73) Proprietor: **Btech Inc.**
**Rockaway, NJ 07866 (US)**

(72) Inventors:
• **Leonard, Timothy Joseph**
**East Greenwich, 02818 (US)**
• **Leonard, Thomas J**
**Rockaway, 07866 (US)**

(74) Representative: **Smith, Jeremy Robert et al**
**Kilburn & Strode LLP**
**Lacon London**
**84 Theobalds Road**
**London WC1X 8NL (GB)**

(56) References cited:
CA-A1- 3 117 022     DE-A1-102018 220 494
US-A1- 2018 095 140     US-A1- 2020 081 070
US-A1- 2021 033 680

## Description

TECHNICAL FIELD

The present disclosure pertains generally to battery monitors, and more specifically to predicting health or life span of a single battery or string of connected batteries.

BACKGROUND

Uninterruptible power supply (UPS) systems are costly investments that require occasional maintenance over the lifetime of the system. A single faulty battery in a string of batteries connected in series causes the entire string of batteries to be faulty. The decision a buyer of UPS systems confronts is whether to replace an entire system of batteries all at once, (e.g., for a lead acid battery system, replacement generally occurs within three to six years from the start of service), or to replace individual batteries in order to prolong the useful life of the entire string of batteries. It is desirable to minimize the cost of battery replacement over time. Prior art battery state-of-health measurement and estimation arrangements using neural networks are known from US2021/033680, US2020/081070, DE102018220494, US2018/095140, and CA3117022.

BRIEF SUMMARY

An invention is set out in the independent claims.

Embodiments disclosed herein are directed to a neural network for estimating battery health and predicting when a battery may reach the end of its useful life. Embodiments are disclosed which may be used to evaluate either individual batteries, systems of one or more interconnected batteries (e.g., a string of batteries), or both.

The capability to accurately predict when a battery will reach its useful life enables forward looking management decisions regarding when to replace a battery or a system of batteries; forward looking budgeting decisions regarding the cost of battery replacement; minimization of costs over time associated with battery replacement; maximization of battery system life span; and providing an informed estimate to supply missing measurement data or replace anomalous measurement data in a battery monitoring system.

Embodiments of the disclosure are able to accurately predict N time periods in advance (e.g., N=13, 26, 39, or 52 weeks) when a battery will reach a measured value (e.g., a measured impedance) that is indicative of end of useful life (e.g., measured impedance may be 30% - 50% greater than an initial impedance measurement).

Embodiments of the disclosure are able to optimize the cost function for a battery management schedule where individual batteries of a system are replaced prior to replacing the entire system, or a string within a system. To solve the cost function, and since costs are known, the problem may be addressed by predicting the end of life of each battery in a string. With a model of time, battery replacement costs may be calculated over the expected length of time a string of batteries will last.

According to one or more embodiments of a system for estimating a state of health of a battery, the system includes:

an input device;
a first neural network trained to estimate future battery data based on battery data obtained from a battery monitor over a first time period;
an output device;
a digital processor; and
a permanent memory comprising computer readable instructions to physically cause the digital processor to perform steps of:

receiving, from the input device, battery data obtained from the battery monitor monitoring the battery;
formatting the battery data as a battery data point;
storing the battery data point as an element of a first battery data vector of N elements wherein the first battery data vector additionally comprises N-1 sequential battery data points, each of the battery data points comprising a measurement time;
inputting the first battery data vector into the first neural network;
formatting, by the first neural network, an first output vector of N elements, wherein the first output vector includes the estimated future battery data for a second time period subsequent to the first time period; and
outputting, by the output device, a health indicator of the battery based at least in part upon the first output vector.

According to one or more embodiments, the system includes:

a second neural network trained to estimate the state of health of the battery based on the battery data obtained from the battery monitor over the first time period; and
the steps performed by the digital processor further include:

generating, based at least in part upon the battery data, a second battery data vector of N elements;
inputting the second battery data vector into the second neural network;
formatting, by the second neural network, an second output vector of N elements, wherein the second output vector includes state of health data for at least a portion of the first time period; and wherein, the health indicator of the battery is based upon at least one of the first output vector and the second output vector.

According to one or more embodiments, the steps performed by the digital processor further include generating, based upon the first battery data vector and the second battery data vector, a third battery data vector; and wherein, the health indicator of the battery is further based upon the third battery data vector.

According to one or more embodiments, the steps performed by the digital processor further include inputting the second output vector into the first neural network.

According to one or more embodiments, the steps performed by the digital processor further include inputting the first output vector into the second neural network.

According to one or more embodiments, each of the elements of the second battery data vector includes at least one of an impedance rise and a voltage rise.

According to one or more embodiments, each of the elements of the second battery data vector further includes time.

According to one or more embodiments, the second neural network is trained to estimate the state of health of a plurality of interconnected batteries; and the battery data is obtained from monitoring at least one of the plurality of interconnected batteries.

According to one or more embodiments, the battery data is obtained from monitoring all of the plurality of interconnected batteries.

According to one or more embodiments, the difference between the measurement time associated with a battery data point and the measurement time associated with an immediately subsequent battery data point defines a measurement interval; and the measurement interval is variable over the N elements of the first battery data vector.

According to one or more embodiments, the first neural network is trained to estimate future battery data for a plurality of interconnected batteries; and the battery data is obtained from monitoring at least one of the plurality of interconnected batteries.

According to one or more embodiments, the battery data is obtained from monitoring all of the plurality of interconnected batteries.

According to one or more embodiments, each of the battery data points includes values of at least one of a voltage of the battery, a impedance of the battery, an internal temperature of the battery, an ambient temperature of the battery, and a time.

According to one or more embodiments, the system includes the battery monitor.

According to one or more embodiments of a method of estimating a state of health of a battery, the method comprises:

    obtaining battery data from a battery monitor monitoring the battery, the battery data corresponding to a first time period;

    training a first neural network to estimate future battery data based on the battery data;

    transmitting, from an input device to a digital processor, battery data obtained from the battery monitor;

    formatting, by the digital processor, the battery data as a battery data point;

    storing the battery data point as an element of a first battery data vector of N elements wherein the first battery data vector additionally comprises N-1 sequential battery data points, each of the battery data points comprising a measurement time;

    inputting the first battery data vector into the first neural network;

    formatting, by the first neural network, an first output vector of N elements, wherein the first output vector includes the estimated future battery data for a second time period subsequent to the first time period; and

    outputting, by an output device, a health indicator of the battery based at least in part upon the first output vector.

According to one or more embodiments, the method includes:

    training a second neural network to estimate the state of health of the battery based on the battery data obtained from the battery monitor over the first time period;

    generating, by the digital processor, based at least in part upon the battery data, a second battery data vector of N elements;

    inputting the second battery data vector into the second neural network;

    formatting, by the second neural network, an second output vector of N elements, wherein the second output vector includes state of health data for at least a portion of the first time period; and

    wherein, the health indicator of the battery is based upon at least one of the first output vector and the second output vector.

According to one or more embodiments, the method includes:

    generating, by the digital processor, based upon the first battery data vector and the second battery data vector, a third battery data vector; and

    wherein, the health indicator of the battery is further based upon the third battery data vector.

According to one or more embodiments, the method includes:
inputting the second output vector into the first neural network.

According to one or more embodiments, the method includes:
inputting the first output vector into the second neural network.

According to one or more embodiments, the method includes:

obtaining the battery data from monitoring at least one of a plurality of interconnected batteries; and training the second neural network to estimate the state of health of the plurality of interconnected batteries based on the battery data.

According to one or more embodiments, the method includes:
obtaining the battery data from monitoring all of the plurality of interconnected batteries.

According to one or more embodiments, the method includes:

obtaining the battery data from monitoring at least one of a plurality of interconnected batteries; and training the first neural network to estimate future battery data for the plurality of interconnected batteries based on the battery data.

According to one or more embodiments, the method includes:
obtaining the battery data from monitoring all of the plurality of interconnected batteries.

These and other aspects of the embodiments will be better appreciated and understood when considered in conjunction with the following description and the accompanying drawings. The following description, while indicating various embodiments and details thereof, is given by way of illustration and not of limitation. Many substitutions, modifications, additions, or rearrangements may be made within the scope of the embodiments, and the embodiments may include all such substitutions, modifications, additions, or rearrangements.

BRIEF DESCRIPTION OF THE DRAWINGS

Non-limiting and non-exhaustive embodiments of the neural network for estimating battery health are described with reference to the following figures, wherein like reference numerals refer to like parts throughout the various views unless otherwise specified.

FIG. 1 is schematic illustration of a system for estimating a state of health of a battery.
FIG. 2 illustrates a method of estimating a state of health of a battery.
FIG. 3 is a schematic of an embodiment of a first neural network of the system.
FIG. 4 is a schematic of another embodiment of a first neural network of the system.
FIG. 5 is an illustration of data structure formats for a neural network of the system.
FIG. 6 is a graphical representation of an output of a neural network of the system.
FIG. 7 is an illustration of additional embodiments of data structure formats for a neural network of the system.
FIG. 8 is another graphical representation of an output of a neural network of the system.
FIG. 9 is an illustration of data structure formats for an input of a neural network of the system.
FIG. 10 is an illustration of data structure formats for an output of a neural network of the system.
FIG. 11 is an illustration of another embodiment of data structure formats for a neural network of the system.
FIG. 12 is a graphical representation of another output of a neural network of the system.
FIG. 13 is an illustration of another embodiment of data structure formats for a neural network of the system.
FIG. 14 is a graphical representation of another output of a neural network of the system.
FIG. 15 is a graphical representation of another output of a neural network of the system.

Skilled artisans will appreciate that elements in the figures are illustrated for simplicity and clarity and have not necessarily been drawn to scale. For example, the dimensions of some of the elements in the figures may be exaggerated relative to other elements to help improve understanding of various embodiments. Also, common but well-understood elements that are useful or necessary in a commercially feasible embodiment are often not depicted in order to facilitate a less obstructed view of these various embodiments.

DETAILED DESCRIPTION

The detailed description describes non-limiting exemplary embodiments. Any individual features may be combined with other features as required by different applications for at least the benefits described herein. As used herein, the term "about" means plus or minus 10% of a given value unless specifically indicated otherwise.

As used herein, a "computer-based system" comprises an input device for receiving data, an output device for outputting data in tangible form (e.g. printing or displaying on a computer screen), a permanent memory for storing data as well as computer code, and a microprocessor for executing computer code wherein said computer code resident in said permanent memory will physically cause said microprocessor to read-in data via said input device, process said data within said microprocessor and output said processed data via said output device.

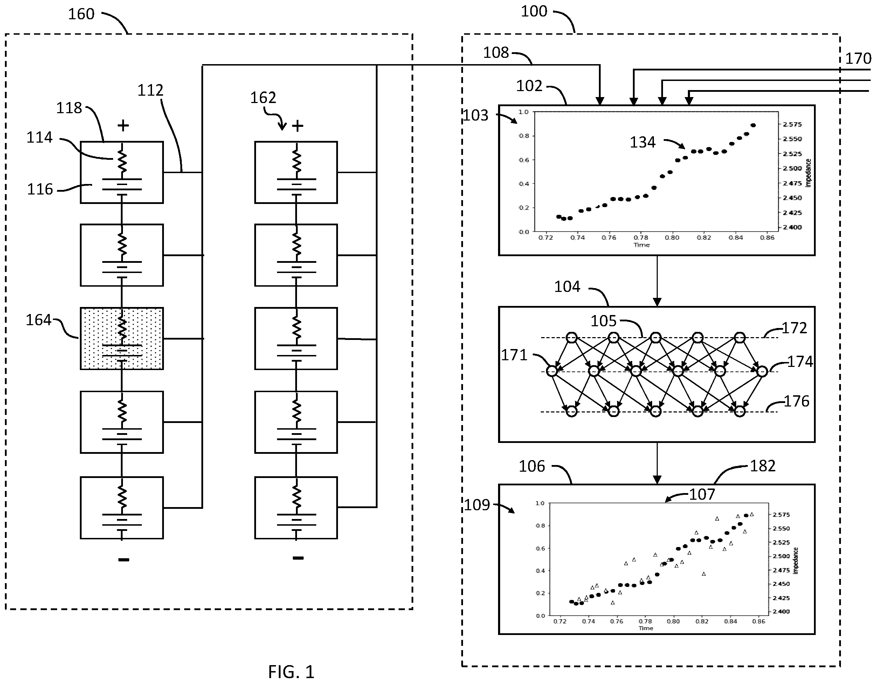

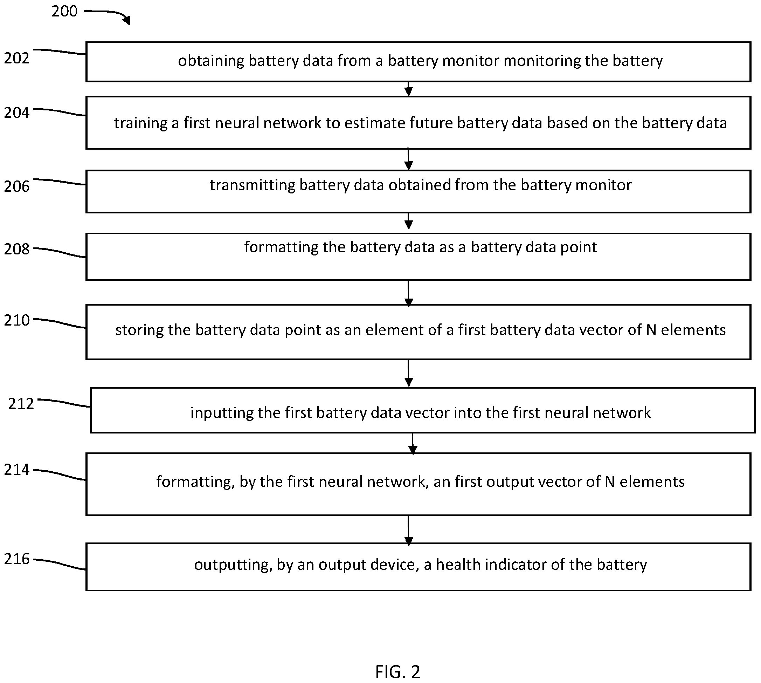

FIG. 1 is schematic illustration of a system 100 for estimating a state of health of a battery. FIG. 2 illustrates a method 200 of estimating a state of health of a battery.

Referring collectively to figures 1 and 2, a system 100 for estimating a state of health of a battery may comprise:

> an input device 102;
> a first neural network 105 trained to estimate future battery data based on battery data obtained from a battery monitor 112 over a first time period;
> an output device 106;
> a digital processor 104; and
> a permanent memory comprising computer readable instructions to physically cause the digital processor to perform the steps 200 of:

> > i) receiving, from the input device, battery data obtained 202 from the battery monitor monitoring the battery 118;
> > ii) formatting 208 the battery data as a battery data point;
> > iii) storing 210 the battery data point as an element of a first battery data vector of N elements wherein the first battery data vector additionally comprises N-1 sequential battery data points, each of the battery data points associated with a measurement time;
> > iv) inputting 212 the first battery data vector into the first neural network;
> > v) formatting 214, by the first neural network 105, an first output vector of N elements, wherein the first output vector includes the estimated future battery data for a second time period subsequent to the first time period; and
> > vi) outputting 216, by the output device 106, a health indicator of the battery based at least in part upon the first output vector.

The battery many be any type of battery located in any type of facility 160. A non-limiting example would be a 12V valve regulated lead acid (VRLA) battery located in the battery backup of an uninterruptable power supply for a server farm or a data center. Another example would be a lithium battery located in the power supply of an electric car. Another example would be a battery located in a portable electronic device. The battery may be one of a string 162 of batteries connected in series. The data monitored from the battery may be one or more of the battery voltage 116, complex or real impedance 114, battery internal temperature, battery ambient temperature or any other physical property of the battery that might be indicative of the battery health.

The system 100 may multiplex between different batteries in a string, different strings in a facility and different facilities 170 in a set of customers.

The input device 102 in FIG. 1 is shown displaying a graph 103 of exemplary battery impedance data 134 versus time (e.g., weeks). Data may be read at a time interval of about once per week. Data may be read in at any suitable data period such as once per day, once per month or longer or shorter data periods.

The neural net 105 illustrated in figure 1 is a generic representation of a neural net and not necessarily a representation of the actual neural net used in the system. Neural nets generally comprise an input layer 172 for receiving an input vector of data, one or more hidden layers 174 for processing said input vector and an output layer 176 for providing an output vector. The number of nodes 171 in each layer may be any suitable value. The number of input nodes, therefore, does not necessarily have to be the same as the number of output nodes. Thus, whereas the examples provided herein indicate that the number N of input nodes and output nodes N are the same, they could alternatively be different. For example, if the neural net is forecasting future values, then there may be more nodes in the output layer than in the input layer.

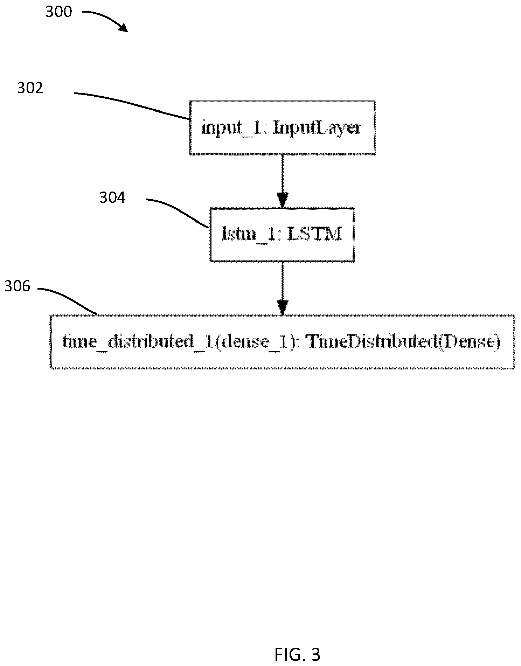

Referring to FIG. 3, a neural network structure 300 used for at least some of the examples provided herein, includes an input layer 302, a long short-term memory (LSTM) layer 304, and a time distributed dense layer 306. The structure is suitable for time series input data and a digital output data with binary values. Other structures may be used, such as additional time distributed hidden layers. Other types of output may be provided.

The system 100 may be a component of an overall remote battery monitoring system. Thus, the one or more battery monitors 112 in the overall remote battery monitoring system may be considered part of the system 100. Similarly, the one or more batteries 118 being monitored may be considered part of the system 100.

Communication between any elements of the system may be by any know means, such as wired or wireless communication. The computational tasks of the system may be performed by any suitable computation means, such as a CPU, vCPU, distributed, local, onsite or cloud based computational system.

**Neural Net Monitoring**

Neural networks may overcome some of the problems of polynomial curve fitting when applied to battery monitoring data. Often an input data set may include large, or anomalous, spikes in the impedance measurement, or missing data altogether. Such spikes may happen somewhere in the first half of a battery's life. A model that accounts for variance in the data over time would flag every instance of a data spike, and attempts to ignore or limit the impact of these outliers may involve undesirable manipulation of, or limitations on, the input data. Such manipulation may dull the model's ability to detect significant changes. On the other hand, when there is adequate history for the neural net to see, the neural net learns to ignore data spikes that occur too early in a battery's lifetime. Neural networks can do this without any special instruction. Neural networks can work with multivariate inputs better than polynomial fitting. In the case of battery monitoring, voltage is difficult to model with a polynomial. Neural networks can improve accuracy in some tasks when voltage is included as a feature.

The neural network programming code used in the below examples is called Keras. It is a high-level software prototyping interface for the TensorFlow library for machine learning. The code used to design the neural network architecture was adapted from the website machinelearningmastery.com.

There are several variables measured that are used in battery monitoring. These include impedance, voltage, unit temperature, ambient temperature, and time. Not all variables are necessary to accurately classify battery change out. The most useful variable is impedance, however it is possible to include the other variables and get good results. Including certain variables and excluding others can change results. It is also possible to change the architecture of the neural net by adding layers or subtracting layers. There are many parameters used to tune neural networks and these parameters can affect results.

The periodic measurement of battery data may introduce the problem of data being collected at irregular intervals. The output of the neural network cannot be represented on a fixed time axis if data is not collected regularly. In real time, for a real use case, it cannot be assumed that data has been collected at fixed intervals. The way data is collected creates formatting issues that make fixed interval models more difficult to implement. A neural network that does not rely on inputs that have fixed intervals is preferred.

Embodiments of the neural networks presented herein address the problem of data being collected at irregular intervals. It is not necessary to assume that data is collected at regular intervals for the neural network to work. In this way, the neural network has more robust applications than an alternative model that relies on data being measured at regular intervals. The present system includes the measurement's time (e.g., in seconds) in both the input and output to the neural network. The neural network learns the time axis in addition to the other variables, and predicts both impedance, or other properties of interest, and the expected time the measurement will take place.

Measured values can be manipulated to create derivative representations of the measurements, for instance, impedance rise and voltage rise. These derivative values can also be used as input to the neural network, however, the neural network may perform using either one or both of the measured or derivative values; for example, either one or both of the impedance value or impedance rise value may be used.

Neural net algorithms require all inputs have the same dimension. This necessitates the input format be large enough to represent the largest possible data point in the data set. The life span of a 12 volt battery used in industry can exceed 6 years. Having measurements taken at weekly intervals, the number of measurements taken over the lifetime of a battery may exceed 300. This introduces the problem of having to represent data with a dimension in excess of 300 to capture the entire lifespan of any and all batteries.

In general, LSTM neural networks perform best on shorter sequences due to the vanishing gradient problem. While a sequence of length 300 is tolerable for LSTMs, it is not preferred. Additionally, new data may exceed the finite limits imposed by a fixed data representation.

Compounding the problem of a large time dimension is the multiplicative effect of having several variables. Entire histories of multiple variables increase the size of the data by an order of magnitude. Additionally, if the data were to include more than one battery, the size of the data increases by another order of magnitude. For large scale battery operations monitoring millions of batteries this becomes a problem of scale.

Because neural net algorithms require all inputs have the same dimension and most data will be smaller than the largest data point, most data points in the data set will be sparse. Large data formats may have the problem of being sparse because the input format must be large enough to fit the largest possible data size even if only a portion of that data format is used by most of the data. As a result only data points that occur near the end of the battery life span will fill the entire dimension of the neural net input. Otherwise, for data points that occur earlier in the battery life time, the input vector of the neural net will have many empty values. The sparse nature of large dimensional inputs can be challenging for neural networks.

For first neural network described herein, also referred to as the N-period model, the number N of measurements used to represent a battery is significantly less than the number of total measurements taken over the average battery lifetime. For example, N may be about 30 while the total number of measurements over a battery life may be about 300. This is possible by the use of the impedance rise variable. Rather than inefficiently representing the entire history of a battery, the impedance rise variable is the proportion of the most recent impedance measurement for a battery to the measurement of impedance taken at the beginning of its life (i.e., the initial impedance value). The impedance rise variable is an historical indicator of a battery that dispenses with the need to explicitly represent the entire life span of a battery. As a result the inputs are not sparse.

Further, predicting impedance rise is a valuable tool when determining when a battery will fail. Since the proportional rise in impedance is used to determine battery failure, not the hard value of impedance itself, impedance rise is the preferred metric that can be applied across all impedance values and readily lends itself to interpretation.

Rather than predicting a single value at some point N time periods in the future, the first neural network predicts all N points between time 1 and time N. This gives the model flexibility to produce actionable results over a desired time frame. In the case of battery monitoring, data may be collected weekly, for example 26 data points may represent 26 weeks, or six months. The output produces a predicted value for all 26 weeks which enables shorter term analysis as well. Suppose you have a budget meeting in 3 months, this model may provide a prediction at 3 months to coincide with when you would make budgetary decisions.

The impedance rise variable also improves the performance of the model, allowing an input which does not include the raw impedance measurement, and attaining state of the art results.

Using impedance rise as an input rather than the raw value of impedance makes the model agnostic to the raw values of impedance. This feature is beneficial, as initial values of impedance vary significantly across individual batteries. The training sample of batteries will therefore include a range of initial values. The range of different initial values may or may not be representative of the complete population of batteries. For example, the training sample may include a random sample of batteries, or it may include only a curated sample of batteries, as may be more beneficial to model performance. In this way, the selected representation of the range of initial impedance measurements may have a beneficial or deleterious effect on model performance. Using impedance rise as a model input rather than the raw value of impedance improves performance and enables broad application with systems having a wide range of initial impedance values.

A voltage rise variable may also be used as input in a manner similar to that described for impedance rise.

## Example 1: Predicting Future Data Values of a Battery

A long short-term memory (LSTM) neural net was applied to a past periodic data history of a set of single batteries. The input to the neural net was a vector, V, that contains a sequence of N past data measurements. In the following example, for a single battery, a single measurement includes impedance, voltage, temperature, and ambient temperature. Additionally, the time in seconds from time $N\_0$ to time $N\_t$ is calculated for each of the N measurements in V. Also, for each of the N measurements in V, the rise in impedance from time $N\_0$ to time $N\_t$ was calculated to represent the percentage rise in impedance for a single battery since installation. This input vector of N measurements contains the measurements for a single battery from left to right.

The output of the neural network was a sequence that had the same length as the input, N. It consists of the next N predicted measurements for impedance and time of measurement for a given single battery, from N+1 to M, where M = 2N. In this way the neural net predicts the next N impedance values and the date and time that the next N measurements will take place. While the input and output had the same length in this example, this does not need to be the case. The output M should be greater than N; in other words, the output values occur at times later than the input values. In another example, the length of the input may be 100 (N from 0-99) and length of the output may be 26 (from (N+1)=100, to M=125).

FIG. 3 illustrates a first embodiment of the architecture for the N-period model of this example. The input and output shapes for each layer are given in Table 1. LSTM layer 304 and time distributed layer 306 may be stacked to produce deeper models.

Table 1 illustrates the input and output shapes for the LSTM model. The input and output shapes are tuples read as (batch size, timesteps, features). A single instance of an input sequence for the N-period model has the shape (1, N, F), where 1 is the number of sequences (batch size), N is the number of timesteps, and F is the number of features: impedance, voltage, unit temperature, ambient temperature, time, or percent rise in impedance. The parameter D is the dimension of the LSTM, and Y is the dimension of the output that corresponds to the number of values predicted at each timestep.

**Table 1.**

| Layer (type) | N periods Output Shape |
|---|---|
| input | (batch, N, F) |
| lstm_1 | (batch, N, D) |
| time_distributed_1 | (batch, N, Y) |

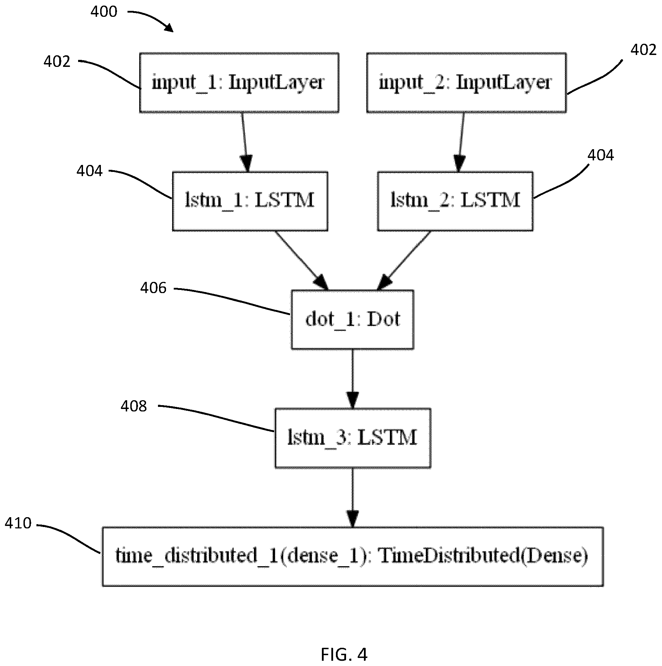

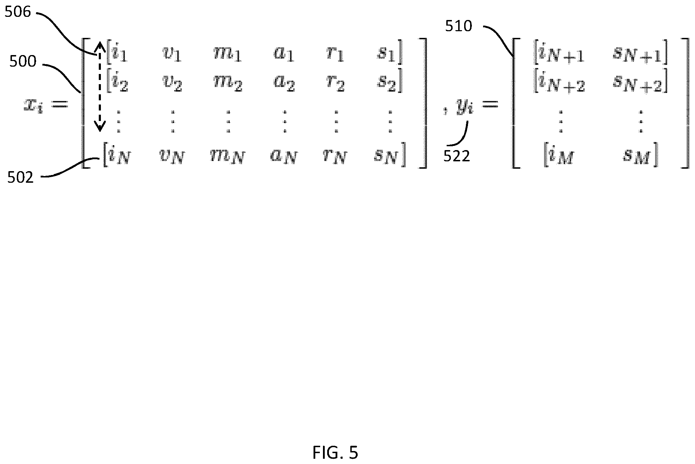

FIG. 4 illustrates a second embodiment of the architecture 400 for the N-period model of this example. Multiple input layers 402 may be combined to provide input to hidden layers of the model. In the shown embodiment input_1 and input_2 are each processed by an LSTM layer 404 and combined by calculating their dot product 406. Input layers 1 and 2 may be different (e.g., spanning different time periods) or may have identical values. An additional LSTM layer 408 and a time distributed layer 410 are included in this example architecture.FIG. 5 is an illustration of data structure formats for input battery data vector 500 (**x_i**) and output vector 510 (**y_i**) for the N period model where M = 2N. Input (**x_i**) is a series of N battery data points, including a battery data point 502 at time N, and N-1 prior sequential training battery data points 506. Each battery data point includes values of six features at time **s,** where **i** is impedance, **v** is voltage, **m** is temperature, **a** is ambient temperature, **r** is percentage rise in impedance compared to the initial value for **i** (the initial value of **i** is the first measurement of impedance at the time this unit was installed, or alternatively a calculated average of the first several impedance measurements for a unit), and **s** is the time in seconds. Output vector 522 (**y_i**) has a length N including the predictions for impedance, **i**, and time, **s**, for the next N periods subsequent to the input time period (i.e., from N+1 to M).

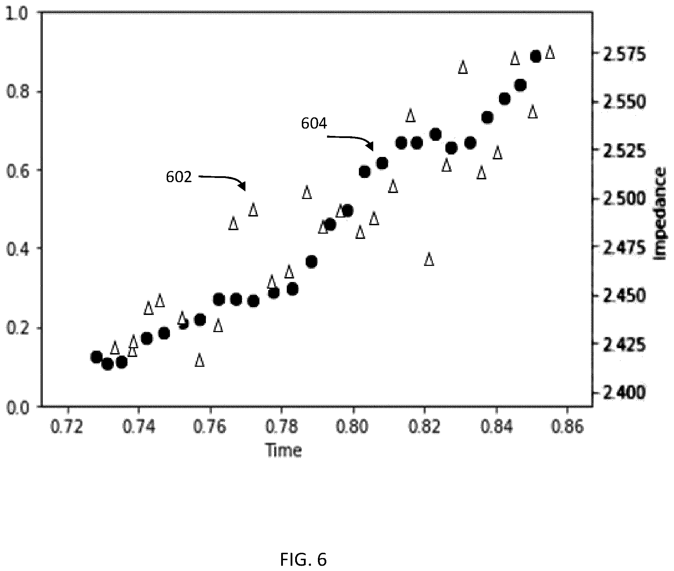

FIG. 6 is a graphical representation of the output of the neural network embodiment of this example, compared with measured values. The measured impedance values 602 over time (represented by triangles) and the predicted values 604 (represented as dots) for the N period model of this example. Time is scaled between 0 and 1.

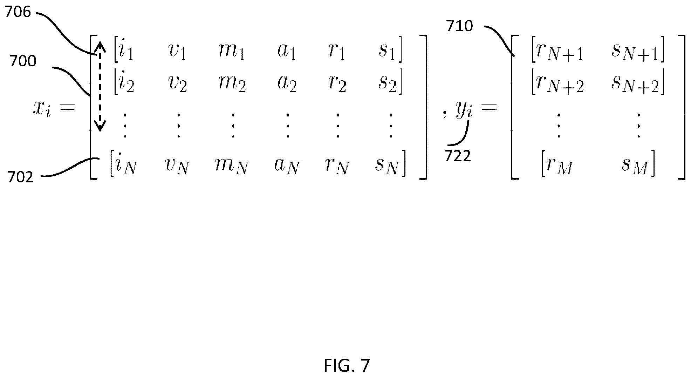

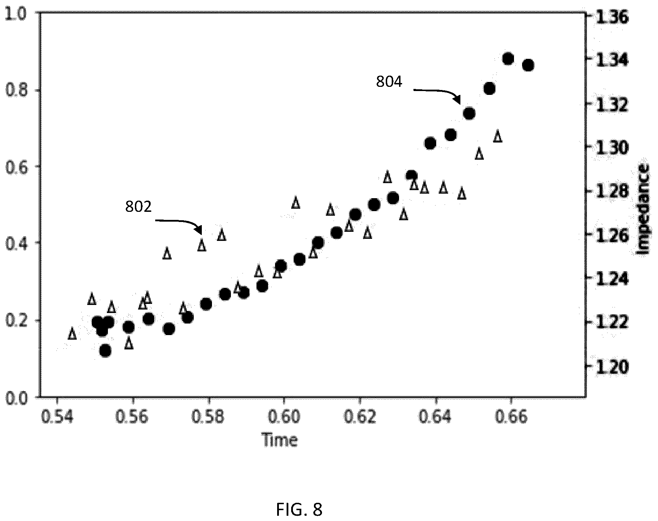

FIG. 7 is an illustration of additional embodiments of data structure formats for input battery data vector 700 (**x_i**) and output vector 710 (**y_i**) for the N period model where M = 2N. Input (**x_i**) is a series of N battery data points, including a battery data point 702 at time N, and N-1 prior sequential training battery data points 706. Each battery data point includes values of six features at time **s**, where **i** is impedance, **v** is voltage, **m** is temperature, **a** is ambient temperature, **r** is percentage rise in impedance compared to the initial value for **i** (the initial value of **i** is the first measurement of impedance at the time this unit was installed, or alternatively a calculated average of impedance for more than one initial period), and **s** is the time in seconds. Output vector 722 (**y_i**) has a length N including the predictions for rise in impedance, **r**, and time, **s**, for the next N periods (from N+1 to M). FIG. 8 is a representation of an embodiment of an output of the neural net compared with values calculated from measured data. The calculated values of rise in impedance 802 over time (represented by triangles) and the predicted values 804 (represented by dots) for the N period model of this example. Time is scaled between 0 and 1.

While the above example presents six particular input features (impedance, voltage, temperature, ambient temperature, rise in impedance, and time; see discussion of FIG. 2) it is noted that other measured or calculated values may be used as input in addition to or in place of those of this example. For example, a voltage rise may be calculated relative to an initial voltage, or any earlier voltage (similarly to the impedance rise value discussed above). Other historical data for the battery may be included, such as a historical high temperature, or a time since battery changeout. In various embodiments, time may be included as an input, an output, or both, as may be desired to improve model performance.

**Example 2: Predicting Future Data Values of a String of Batteries**

For commercial monitoring applications, multiple batteries are placed in serial and parallel configurations to produce the voltage and current necessary to power backup systems such as industrial sized generators. At the 'string' level, batteries are aligned in serial to produce the requisite voltage needed by UPS (uninterrupted power supply) systems. Strings are then put in parallel to provide a power reservoir. The more power required the more strings are used.

The data model described above takes input from a single battery and produces predicted values of impedance and time for that battery. The single battery model does not account for behavior that occurs at the string level. When a single battery in a string of batteries fails, the entire string fails to produce power on demand resulting in an interruption of power. Batteries in serial affect each other as their chemistry deteriorates over time. For instance, when impedance increases due to battery failure in one battery, simultaneously a healthy battery may exhibit aberrant behavior that reverts to normal only after the failed battery is replaced.

Applying the single battery model to the scale of commercial monitoring systems, entire strings are represented in each data point rather than individual batteries. The dimension of the string wise data point is the number of variables, excluding the time variable, for each individual battery in **x_i** (see Figure 6) multiplied by the number of batteries in the string. Since the time variable is the same across all batteries in a string, it only needs to be represented once. The length of **x_i** is N, which is the number of time intervals represented in the sequence.

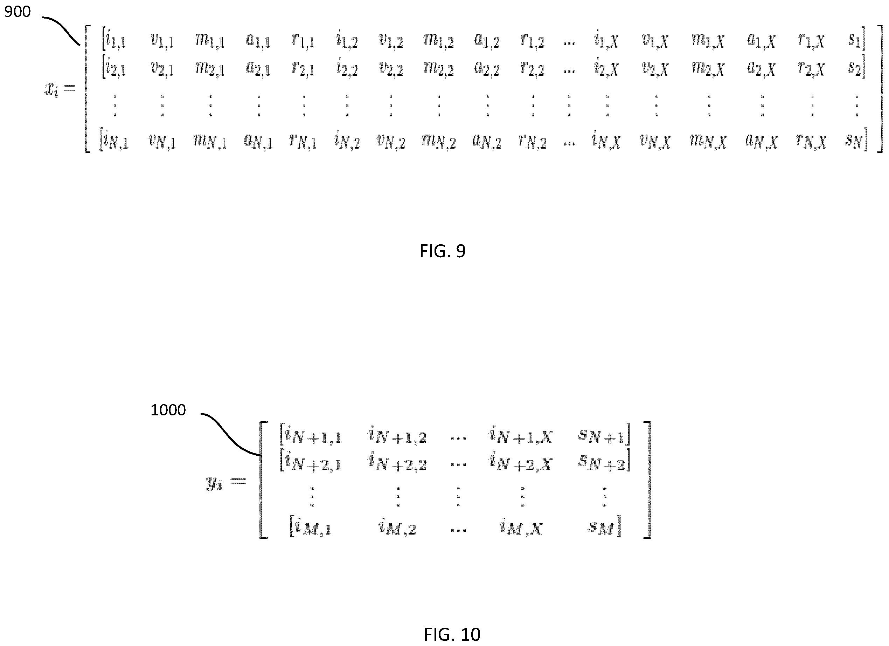

FIG. 9 illustrates a data structure format for input battery data vector 900 (**x_i**) for an N period model for a string of batteries. Input **x_i** is a vector of length N. The input is a series of N data points consisting of the five features for each battery at time **s**, where **i** is impedance, **v** is voltage, **m** is temperature, **a** is ambient temperature, **r** is percentage rise in impedance compared to the initial value for **i**, and **s** is the time in seconds. Each unit X has a measurement at time **s** so that the dimension of a measurement at the string level is the number of variables per unit (**i**, **v**, **m**, **a**, **r**) times the number of units X plus the time variable **s**.

FIG. 10 illustrates a data structure format for output battery data vector 1000 (**y_i**). The output vector has a length N, where M = 2N, consisting of the predictions for impedance, **i**, for each individual unit X and time, **s**, for the next N periods (from N+1 to M).

**Example 3: Modeling State of Health of a Battery**

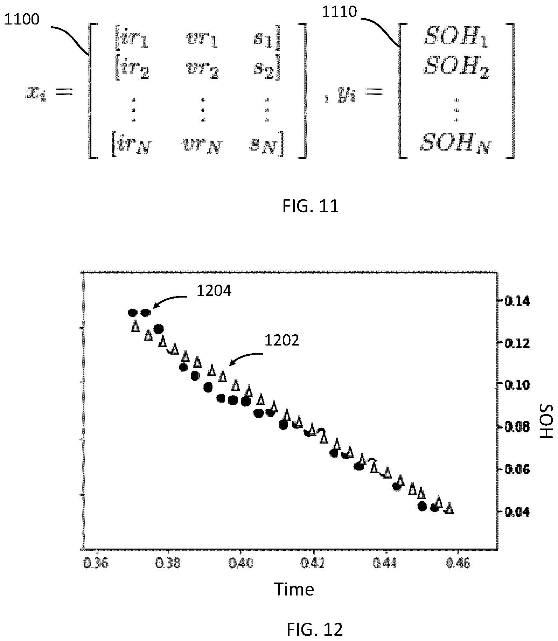

FIG. 11 illustrates embodiments of an input vector 1100 (**x_i**) and output vector 1110 (**y_i**) for the second neural network, also referred to as the State of Health (SOH) model. The input is a series of **N** data points consisting of the features at time **s**, where, **ir** is impedance rise, **vr** is voltage rise, and **s** is the time in seconds. The output is a vector of length N consisting of the values for SOH at time **s** for the last N periods.

FIG. 12 is a graphical representation of the output of the SOH model compared with the true values. The actual values 1202 (triangles) and the predicted values **y_i** 1204 (dots) for the N period model discussed above. Time is scaled between 0 and 1. SOH is the expected time until the battery should be replaced at time **s** for each of the last N periods.

Since the time variable is scaled it is not readily interpreted without an inverse function. For purposes of discussion, assume the maximum number of weeks is 300 or approximately 6 years. A distance of 0.01 is about 3 weeks and the SOH model is counting down to when a battery reaches 1.3 impedance rise, used here as an end of life indicator.

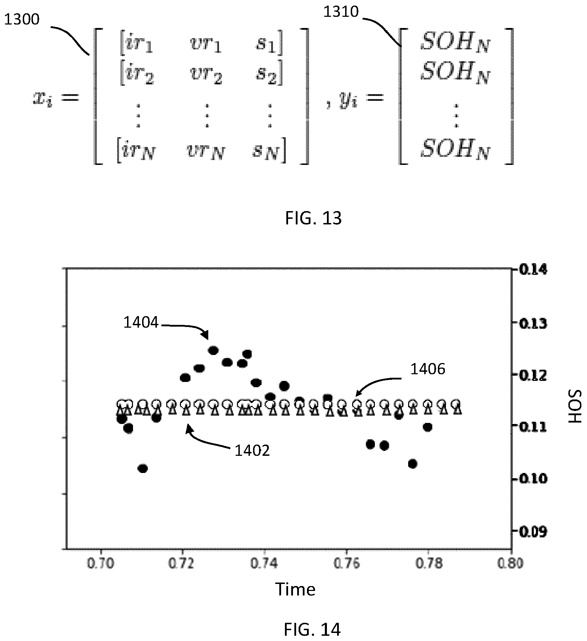

FIG. 13 illustrates embodiments of an input vector 1300 (**x_i**) and output vector 1310 (**y_i**) for the State of Health (SOH) model. The input is a series of N data points consisting of the features at time s. ir is impedance rise, vr is voltage rise, and **s** is the time in seconds. The output is a vector of length N consisting of N values for SOH at time s_N.

FIG. 14 is a graphical representation of the output of the SOH model compared with the true values. The actual values 1402 are shown as triangles and the predicted values **y_i** 1404 are shown as solid dots. The time is scaled between 0 and 1. The estimate for SOH 1406 at time s_N is the average of all N predictions (hollow dots).

It may be commercially beneficial to include a lifetime estimate as either an input, an output or both. An input lifetime estimate may be a manufacturer estimate, a modeled estimate, or an experiential estimate. In a system having multiple interconnected batteries, a single failing battery is known to impact the properties of other batteries in the system. In a model which considers the effects between interconnected batteries, providing an input lifetime estimate may improve the ability of the model to adapt to rapidly changing conditions. For example, if the system experiences early failure of a single battery, the model may reduce the expected lifetime of other batteries in the system. However if, when the failed battery is replaced, an upwardly trending lifetime estimate is provided for connected batteries, the model may respond more rapidly to the change.

Another input value may be an indicator of battery changeout, which may be 0 for an unchanged battery, and **s** (where **s** rtime of changeout) for a battery which has been individually replaced.

Providing lifetime estimate as output can inform battery replacement decisions and allows the operator to optimize the cost of system maintenance. For example, an operator may be able to model the effects of replacing single failing batteries on the overall system lifetime, as compared to replacing all the batteries of a system at once. In an embodiment, the input includes an indicator of battery changeout and the output includes a lifetime estimate. By varying the battery changeout input to this model, one may study the effects on lifetime estimate. Such a model may directly inform budgeting and maintenance decisions.

**Example 4: Cost Optimization for Battery Replacement**

The cost of a system is a function of initial costs, replacement costs, and time.

As an example, suppose a string of batteries costs $10,400 to install. After 4 years, some batteries need to be replaced. If it costs $260 per unit to replace, how many units can be replaced before it is more cost efficient to replace the entire system. Assume the model predicts the string has 1 more year before failure if the batteries are replaced.

Take the maximum of **P_r** such that:

$$P\_r\,/1 \le P\_i\,/4$$

$$P\_r \le 2600$$

Divide **P_r** by the price per unit to get the number of units:

$$2600/260 = 10$$

A maximum of 10 units can be replaced before it is more cost effective to replace the entire string.

**Replacing Missing or Corrupted Data**

The N-period prediction model may be used to supplement the SOH model. For example, in the case of premature battery failure and the effects across a string, a failed battery can cause other batteries in the string to produce abnormally low or abnormally high impedance. These batteries are still functional, however, and do not need to be replaced. Because the data is anomalous from otherwise healthy batteries, the input to the SOH model is anomalous as well and may cause the model to provide inaccurate output. The N-period prediction model solves this problem by replacing irregular data with smooth data that is closer to the expected measurement. It is then possible to apply the SOH model to the predicted data rather than to data that is known to be corrupted.

In a similar manner, the N-period prediction model is applicable to replacing missing data or other types of corrupted data and measurement errors common with battery systems.

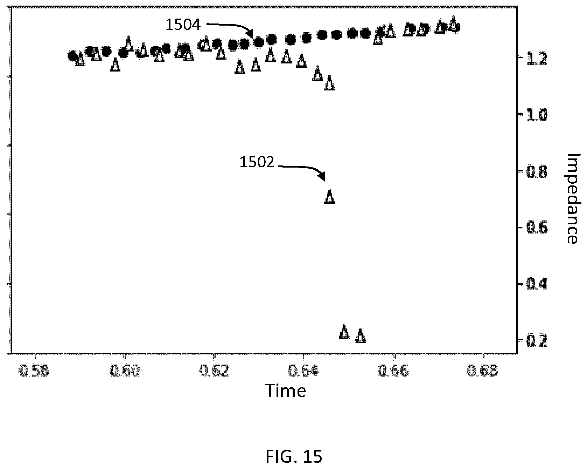

FIG. 15 is a graphical representation of the output of the N period model versus the true values. The predicted values 1504 (dots) may replace the actual values 1502 (triangles) for certain applications. In this example the actual values are influenced by some system factor causing the impedance measurement to temporarily dip (between time 0.64-0.66) and then return to the previous trajectory when the influencing factor is removed.

In terms of use, a method 200 of estimating a state of health of a battery includes the steps of (refer to FIGS. 1 & 2):

> obtaining 202 battery data from a battery monitor monitoring the battery, the battery data corresponding to a first time period;
> training 204 a first neural network to estimate future battery data based on the battery data;
> transmitting 206, from an input device 102 to a digital processor 104, battery data obtained from the battery monitor;
> formatting 208, by the digital processor, the battery data as a battery data point;
> storing 210 the battery data point as an element of a first battery data vector of N elements wherein the first battery data vector additionally comprises N-1 sequential battery data points, each of the battery data points associated with a measurement time;
> inputting 212 the first battery data vector into the first neural network;
> formatting 214, by the first neural network, an first output vector of N elements, wherein the first output vector includes the estimated future battery data for a second time period subsequent to the first time period; and
> outputting 216, by an output device 106, a health indicator of the battery based at least in part upon the first output vector.

In some embodiments, the method further includes:

> training a second neural network to estimate the state of health of the battery based on the battery data obtained from the battery monitor over the first time period;
> generating, by the digital processor, based at least in part upon the battery data, a second battery data vector of N elements;
> inputting the second battery data vector into the second neural network;
> formatting, by the second neural network, an second output vector of N elements, wherein the second output vector includes state of health data for at least a portion of the first time period; and
> wherein, the health indicator of the battery is based upon at least one of the first output vector and the second output vector.

In some embodiments, the method further includes:

> generating, by the digital processor, based upon the first battery data vector and the second battery data vector, a third battery data vector; and
wherein, the health indicator of the battery is further based upon the third battery data vector.

In some embodiments, the method further includes inputting the second output vector into the first neural network.

In some embodiments, the method further includes inputting the first output vector into the second neural network.

In some embodiments, the method further includes:

> obtaining the battery data from monitoring at least one of a plurality of interconnected batteries; and
> training the second neural network to estimate the state of health of the plurality of interconnected batteries based on the battery data.

In some embodiments, the method further includes obtaining the battery data from monitoring all of the plurality of interconnected batteries.

In some embodiments, the method further includes obtaining the battery data from monitoring at least one of a plurality of interconnected batteries; and training the first neural network to estimate future battery data for the plurality of interconnected batteries based on the battery data.

In some embodiments, the method further includes obtaining the battery data from monitoring all of the plurality of interconnected batteries.

In some embodiments, the method further includes each of the elements of the second battery data vector including at least one of an impedance rise and a voltage rise.

In some embodiments, the method further includes each of the elements of the second battery data vector including time.

In some embodiments, the method further includes:

> the difference between the measurement time associated with a battery data point and the measurement time associated with an immediately subsequent battery data point defines a measurement interval; and
> the measurement interval is variable over the N elements of the first battery data vector.

In some embodiments, the method further includes each of the battery data points including values of at least one of a voltage of the battery, a impedance of the battery, an internal temperature of the battery, an ambient temperature of the battery, and a time.

In some embodiments, the method further includes providing the battery monitor 112.

The embodiments of the neural network for estimating battery health methods of use described herein are exemplary and numerous modifications, combinations, variations, and rearrangements can be readily envisioned to achieve an equivalent result, all of which are intended to be embraced within the scope of the appended claims. Further, nothing in the above-provided discussions of the systems and methods should be construed as limiting the invention to a particular embodiment or combination of embodiments.

**Claims**

1. A system for estimating a state of health of a battery, the system comprising:

an input device (102);
a first neural network (105) trained to estimate future battery data based on battery data obtained from a battery monitor over a first time period;
an output device (106);
a digital processor (104); and
a permanent memory comprising computer readable instructions to physically cause the digital processor to perform steps of:

receiving, from the input device, battery data obtained (202) from the battery monitor monitoring the battery;
formatting (208) the battery data as a battery data point; storing (210) the battery data point as an element of a first battery data vector of N elements wherein the first battery data vector additionally comprises N-1 sequential battery data points, each of the battery data points comprising a measurement time;
inputting (212) the first battery data vector into the first neural network;
formatting (214), by the first neural network, an first output vector of N elements, wherein the first output vector includes the estimated future battery data for a second time period subsequent to the first time period; and
outputting (216), by the output device, a health indicator of the battery based at least in part upon the first output vector.

2. The system of claim 1, comprising:

a second neural network trained to estimate the state of health of the battery based on the battery data obtained from the battery monitor over the first time period; and
the steps performed by the digital processor further include:

generating, based at least in part upon the battery data, a second battery data vector of N elements;
inputting the second battery data vector into the second neural network;
formatting, by the second neural network, an second output vector of N elements, wherein the second output vector includes state of health data for at least a portion of the first time period; and
wherein, the health indicator of the battery is based upon at least one of the first output vector and the second output vector.

3. The system of claim 2 wherein the steps performed by the digital processor comprise:

generating, based upon the first battery data vector and the second battery data vector, a third battery data vector, and
wherein, the health indicator of the battery is based upon the third battery data vector.

4. The system of claim 2 or 3 wherein the steps performed by the digital processor comprise:

inputting the second output vector into the first neural network; and/or
inputting the first output vector into the second neural network.

5. The system of any of claims 2-4 wherein each of the elements of the second battery data vector comprises at least one of an impedance rise and a voltage rise, and/or wherein each of the elements of the second battery data vector comprises time.

6. The system of any of claims 2-5 wherein:

the second neural network is trained to estimate the state of health of a plurality of interconnected batteries; and
the battery data is obtained from monitoring at least one of the plurality of interconnected batteries.

7. The system of any of claims 1-6 wherein:

the difference between the measurement time associated with a battery data point and the measurement time associated with an immediately subsequent battery data point defines a measurement interval; and
the measurement interval is variable over the N elements of the first battery data vector.

8. The system of any of claims 1-7 wherein:

the first neural network is trained to estimate future battery data for a plurality of interconnected batteries; and

the battery data is obtained from monitoring at least one of the plurality of interconnected batteries.

9. The system of any of claims 1-8 wherein each of the battery data points includes values of at least one of a voltage of the battery, a impedance of the battery, an internal temperature of the battery, an ambient temperature of the battery, and a time.

10. A method of estimating a state of health of a battery, the method comprising:

obtaining (202) battery data from a battery monitor monitoring the battery, the battery data corresponding to a first time period;
training (204) a first neural network to estimate future battery data based on the battery data;

transmitting (206), from an input device to a digital processor, battery data obtained from the battery monitor;
formatting (208), by the digital processor, the battery data as a battery data point;

storing (210) the battery data point as an element of a first battery data vector of N elements wherein the first battery data vector additionally comprises N-1 sequential battery data points, each of the battery data points comprising a measurement time;
inputting (212) the first battery data vector into the first neural network;

formatting (214), by the first neural network, an first output vector of N elements, wherein the first output vector includes the estimated future battery data for a second time period subsequent to the first time period; and
outputting (216), by an output device, a health indicator of the battery based at least in part upon the first output vector.

11. The method of claim 10, comprising:

training a second neural network to estimate the state of health of the battery based on the battery data obtained from the battery monitor over the first time period;
generating, by the digital processor, based at least in part upon the battery data, a second battery data vector of N elements;
inputting the second battery data vector into the second neural network; and
formatting, by the second neural network, an second output vector of N elements, wherein the second output vector includes state of health data for at least a portion of the first time period, wherein, the health indicator of the battery is based upon at least one of the first output vector and the second output vector.

12. The method of claim 11, comprising:

generating, by the digital processor, based upon the first battery data vector and the second battery data vector, a third battery data vector, wherein the health indicator of the battery is further based upon the third battery data vector.

13. The method of claim 11 or 12, comprising:

inputting the second output vector into the first neural network; and/or
inputting the first output vector into the second neural network.

14. The method of any of claims 11-13, comprising:

obtaining the battery data from monitoring at least one of a plurality of interconnected batteries; and
training the second neural network to estimate the state of health of the plurality of interconnected batteries based on the battery data.

15. The method of any of claims 10-14, comprising:

obtaining the battery data from monitoring at least one of a plurality of interconnected batteries; and
training the first neural network to estimate future battery data for the plurality of interconnected batteries based on the battery data.

**Patentansprüche**

1. System zum Schätzen des Gesundheitszustands einer Batterie, wobei das System Folgendes umfasst:

eine Eingabevorrichtung (102);
ein erstes neuronales Netz (105), das geschult ist, zukünftige Batteriedaten anhand von Batteriedaten, die von einem Batteriemonitor über eine erste Zeitperiode erhalten werden, zu schätzen;
eine Ausgabevorrichtung (106);
einen digitalen Prozessor (104); und
einen permanenten Speicher, der computerlesbare Anweisungen enthält, um physikalisch zu bewirken, dass der digitale Prozessor die folgenden Schritte ausführt:

Empfangen von der Eingabevorrichtung von Batteriedaten, die von dem Batteriemonitor, der die Batterie überwacht, erhalten werden (202);

Formatieren (208) der Batteriedaten als einen Batteriedatenpunkt;

Speichern (210) des Batteriedatenpunkts als ein Element eines ersten Batteriedatenvektors von N Elementen, wobei der erste Batteriedatenvektor zusätzlich N-1 aufeinanderfolgende Batteriedatenpunkte umfasst, wobei jeder der Batteriedatenpunkte eine Messzeit umfasst;

Eingeben (212) des ersten Batteriedatenvektors in das erste neuronale Netz;

Formatieren (214) durch das erste neuronale Netz eines ersten Ausgabevektors von N Elementen,

wobei der erste Ausgabevektor die geschätzten zukünftigen Batteriedaten für eine auf die erste Zeitperiode folgende zweite Zeitperiode enthält; und

Ausgeben (216) durch die Ausgabevorrichtung eines Gesundheitsindikators der Batterie zumindest teilweise anhand des ersten Ausgabevektors.

2. System nach Anspruch 1, das Folgendes umfasst:

ein zweites neuronales Netz, das geschult ist, den Gesundheitszustand der Batterie anhand der von dem Batteriemonitor über die erste Zeitperiode erhaltenen Batteriedaten zu schätzen; und

wobei die durch den digitalen Prozessor ausgeführten Schritte ferner Folgendes enthalten:

Erzeugen zumindest teilweise anhand der Batteriedaten eines zweiten Batteriedatenvektors von N Elementen;

Eingeben des zweiten Batteriedatenvektors in das zweite neuronale Netz;

Formatieren durch das zweite neuronale Netz eines zweiten Ausgabevektors von N Elementen, wobei der zweite Ausgabevektor Gesundheitszustandsdaten für mindestens einen Teil der ersten Zeitperiode enthält; und

wobei der Gesundheitsindikator der Batterie auf dem ersten Ausgabevektor und/oder dem zweiten Ausgabevektor beruht.

3. System nach Anspruch 2, wobei die durch den digitalen Prozessor ausgeführten Schritte Folgendes umfassen:

Erzeugen anhand des ersten Batteriedatenvektors und des zweiten Batteriedatenvektors eines dritten Batteriedatenvektors und

wobei der Gesundheitsindikator der Batterie auf dem dritten Batteriedatenvektor beruht.

4. System nach Anspruch 2 oder 3, wobei die durch den digitalen Prozessor ausgeführten Schritte Folgendes umfassen:

Eingeben des zweiten Ausgabevektors in das erste neuronale Netz und/oder Eingeben des ersten Ausgabevektors in das zweite neuronale Netz.

5. System nach einem der Ansprüche 2-4, wobei jedes der Elemente des zweiten Batteriedatenvektors einen Impedanzanstieg und/oder einen Spannungsanstieg umfasst und/oder wobei jedes der Elemente des zweiten Batteriedatenvektors eine Zeit umfasst.

6. System nach einem der Ansprüche 2-5, wobei:

das zweite neuronale Netz geschult ist, den Gesundheitszustand mehrerer miteinander verbundener Batterien zu schätzen; und die Batteriedaten vom Überwachen mindestens einer der mehreren miteinander verbundenen Batterien erhalten werden.

7. System nach einem der Ansprüche 1-6, wobei:

der Unterschied zwischen der Messzeit, die einem Batteriedatenpunkt zugeordnet ist, und der Messzeit, die einem unmittelbar folgenden Batteriedatenpunkt zugeordnet ist, ein Messintervall definiert; und das Messintervall über die N Elemente des ersten Batteriedatenvektors variabel ist.

8. System nach einem der Ansprüche 1-7, wobei:

das erste neuronale Netz geschult ist, zukünftige Batteriedaten für mehrere miteinander verbundene Batterien zu schätzen; und die Batteriedaten vom Überwachen mindestens einer der mehreren miteinander verbundenen Batterien erhalten werden.

9. System nach einem der Ansprüche 1-8, wobei jeder der Batteriedatenpunkte Werte einer Spannung der Batterie und/oder einer Impedanz der Batterie und/oder einer internen Temperatur der Batterie und/oder einer Umgebungstemperatur der Batterie und/oder eine Zeit enthält.

10. Verfahren zum Schätzen des Gesundheitszustands einer Batterie, wobei das Verfahren Folgendes umfasst:

Erhalten (202) von Batteriedaten von einem Batteriemonitor, der die Batterie überwacht, wobei die Batteriedaten einer ersten Zeitperiode entsprechen;

Schulen (204) eines ersten neuronalen Netzes, zukünftige Batteriedaten anhand der Batteriedaten zu schätzen;

Senden (206) von Batteriedaten, die von dem Batteriemonitor erhalten werden, von einer Eingabevorrichtung an einen digitalen Prozessor;

Formatieren (208) durch den digitalen Prozessor der Batteriedaten als einen Batteriedatenpunkt;

Speichern (210) des Batteriedatenpunkts als ein Element eines ersten Batteriedatenvektors von N Elementen, wobei der erste Batteriedatenvektor zusätzlich N-1 aufeinanderfolgende Batteriedatenpunkte umfasst, wobei jeder der Batteriedatenpunkte eine Messzeit umfasst;

Eingeben (212) des ersten Batteriedatenvektors in das erste neuronale Netz;

Formatieren (214) durch das erste neuronale Netz eines ersten Ausgabevektors von N Elementen, wobei der erste Ausgabevektor die geschätzten zukünftigen Batteriedaten für eine auf die erste Zeitperiode folgende zweite Zeitperiode enthält; und

Ausgeben (216) durch eine Ausgabevorrichtung eines Gesundheitsindikators der Batterie zumindest teilweise anhand des ersten Ausgabevektors.

11. Verfahren nach Anspruch 10, das Folgendes umfasst:

Schulen eines zweiten neuronalen Netzes, den Gesundheitszustand der Batterie anhand der von dem Batteriemonitor über die erste Zeitperiode erhaltenen Batteriedaten zu schätzen;

Erzeugen durch den digitalen Prozessor zumindest teilweise anhand der Batteriedaten eines zweiten Batteriedatenvektors von N Elementen;

Eingeben des zweiten Batteriedatenvektors in das zweite neuronale Netz; und

Formatieren durch das zweite neuronale Netz eines zweiten Ausgabevektors von N Elementen, wobei der zweite Ausgabevektor Gesundheitszustandsdaten für mindestens einen Teil der ersten Zeitperiode enthält, wobei der Gesundheitsindikator der Batterie auf dem ersten Ausgabevektor und/oder dem zweiten Ausgabevektor beruht.

12. Verfahren nach Anspruch 11, das Folgendes umfasst:

Erzeugen durch den digitalen Prozessor anhand des ersten Batteriedatenvektors und des zweiten Batteriedatenvektors eines dritten Batteriedatenvektors,

wobei der Gesundheitsindikator der Batterie ferner auf dem dritten Batteriedatenvektor beruht.

13. Verfahren nach Anspruch 11 oder 12, das Folgendes umfasst:

Eingeben des zweiten Ausgabevektors in das erste neuronale Netz; und/oder

Eingeben des ersten Ausgabevektors in das zweite neuronale Netz.

14. Verfahren nach einem der Ansprüche 11-13, das Folgendes umfasst:

Erhalten der Batteriedaten vom Überwachen mindestens einer der mehreren miteinander verbundenen Batterien; und

Schulen des zweiten neuronalen Netzes, den Gesundheitszustand der mehreren miteinander verbundenen Batterien anhand der Batteriedaten zu schätzen.

15. Verfahren nach einem der Ansprüche 10-14, das Folgendes umfasst:

Erhalten der Batteriedaten vom Überwachen mindestens einer der mehreren miteinander verbundenen Batterien; und

Schulen des ersten neuronalen Netzes, zukünftige Batteriedaten für die mehreren miteinander verbundenen Batterien anhand der Batteriedaten zu schätzen.

**Revendications**

1. Système d'estimation de l'état de santé d'une batterie, le système comprenant :

un dispositif d'entrée (102) ;

un premier réseau neuronal (105) formé pour estimer des données de batterie futures en fonction de données de batterie obtenues à partir d'un moniteur de batterie durant une première période ;

un dispositif de sortie (106) ;

un processeur numérique (104) ; et

une mémoire permanente comprenant des instructions lisibles par ordinateur pour amener physiquement le processeur numérique à réaliser des étapes de :

réception, à partir du dispositif d'entrée, de données de batterie obtenues (202) à partir du moniteur de batterie qui surveille la batterie ;

formatage (208) des données de batterie en tant que point de données de batterie ;

stockage (210) du point de données de batterie en tant qu'élément d'un premier vecteur de données de batterie de N éléments, dans lequel le premier vecteur de données de batterie comprend en outre N-1 points de données de batterie séquentiels, chacun des points de données de batterie comprenant un temps de mesure ;

entrée (212) du premier vecteur de données de batterie dans le premier réseau neuronal ;

formatage (214), par le premier réseau neuronal, d'un premier vecteur de sortie de N éléments, dans lequel le premier vecteur de sortie comprend les données de batterie futures estimées pour une deuxième période postérieure à la première période ; et

sortie (216), par le dispositif de sortie, d'un indicateur de santé de la batterie basé au moins en partie sur le premier vecteur de sortie.

2. Système selon la revendication 1, comprenant :

un deuxième réseau neuronal formé pour estimer l'état de santé de la batterie en fonction des données de batterie obtenues à partir du moniteur de batterie durant la première période ; et les étapes réalisées par le processeur numérique comportent en outre :

la génération, en fonction au moins en partie des données de batterie, d'un deuxième vecteur de données de batterie de N éléments ;

l'entrée du deuxième vecteur de données de batterie dans le deuxième réseau neuronal ;

le formatage, par le deuxième réseau neuronal, d'un deuxième vecteur de sortie de N éléments,

dans lequel le deuxième vecteur de sortie comprend des données d'état de santé pour au moins une partie de la première période ; et

dans lequel, l'indicateur de santé de la batterie est basé sur au moins un du premier vecteur de sortie et du deuxième vecteur de sortie.

3. Système selon la revendication 2 dans lequel les étapes réalisées par le processeur numérique comprennent :

la génération, en fonction du premier vecteur de données de batterie et du deuxième vecteur de données de batterie, d'un troisième vecteur de données de batterie, et

dans lequel, l'indicateur de santé de la batterie est basé sur le troisième vecteur de données de batterie.

4. Système selon la revendication 2 ou 3 dans lequel les étapes réalisées par le processeur numérique comprennent :

l'entrée du deuxième vecteur de sortie dans le premier réseau neuronal ; et/ou l'entrée du premier vecteur de sortie dans le deuxième réseau neuronal.

5. Système selon l'une quelconque des revendications 2 à 4 dans lequel chacun des éléments du deuxième vecteur de données de batterie comprend au moins un élément d'une montée d'impédance et d'une montée de tension, et/ou dans lequel chacun des éléments du deuxième vecteur de données de batterie comprend un temps.

6. Système selon l'une quelconque des revendications 2 à 5 dans lequel :

le deuxième réseau neuronal est formé pour estimer l'état de santé d'une pluralité de batteries interconnectées ; et

les données de batterie sont obtenues en surveillant au moins une de la pluralité de batteries interconnectées.

7. Système selon l'une quelconque des revendications 1 à 6 dans lequel :

la différence entre le temps de mesure associé à un point de données de batterie et le temps de mesure associé à un point de données de batterie immédiatement suivant définit un intervalle de mesure ; et

l'intervalle de mesure est variable sur les N éléments du premier vecteur de données de batterie.

8. Système selon l'une quelconque des revendications 1 à 7 dans lequel :

le premier réseau neuronal est formé pour estimer des données de batterie futures pour une pluralité de batteries interconnectées ; et

les données de batterie sont obtenues en surveillant au moins une de la pluralité de batteries interconnectées.

9. Système selon l'une quelconque des revendications 1 à 8 dans lequel chacun des points de données de batterie comporte des valeurs d'au moins une tension de la batterie, une impédance de la batterie, une température interne de la batterie, une température ambiante de la batterie, et un temps.

10. Procédé d'estimation de l'état de santé d'une batterie, le procédé comprenant :

l'obtention (202) de données de batterie à partir d'un moniteur de batterie qui surveille la batterie, les données de batterie correspondant à une première période de temps ;
la formation (204) d'un premier réseau neuronal pour estimer des données de batterie futures en fonction des données de batterie ;
la transmission (206), d'un dispositif d'entrée à un processeur numérique, des données de batterie obtenues à partir du moniteur de batterie ;
le formatage (208), par le processeur numérique, des données de batterie en tant que point de données de batterie ;
le stockage (210) du point de données de batterie en tant qu'élément d'un premier vecteur de données de batterie de N éléments, dans lequel le premier vecteur de données de batterie comprend en outre N-1 points de données de batterie séquentiels, chacun des points de données de batterie comprenant un temps de mesure ;
l'entrée (212) du premier vecteur de données de batterie dans le premier réseau neuronal ;
le formatage (214), par le premier réseau neuronal, d'un premier vecteur de sortie de N éléments,
dans lequel le premier vecteur de sortie comporte les données de batterie futures estimées pour une deuxième période postérieure à la première période ; et
la sortie (216), par un dispositif de sortie, d'un indicateur de santé de la batterie basé au moins en partie sur le premier vecteur de sortie.

11. Procédé selon la revendication 10, comprenant :

la formation d'un deuxième réseau neuronal pour estimer l'état santé de la batterie en fonction des données de batterie obtenues à partir du moniteur de batterie durant la première période ;
la génération, par le processeur numérique, en fonction au moins en partie des données de batterie, d'un deuxième vecteur de données de batterie de N éléments ;
l'entrée du deuxième vecteur de données de batterie dans le deuxième réseau neuronal ; et
le formatage, par le deuxième réseau neuronal, d'un deuxième vecteur de sortie de N éléments, dans lequel le deuxième vecteur de sortie comporte des données d'état de santé pour au moins une partie de la première période,
dans lequel, l'indicateur de santé de la batterie est basé sur au moins un du premier vecteur de sortie et du deuxième vecteur de sortie.

12. Procédé selon la revendication 11, comprenant :

la génération, par le processeur numérique, en fonction du premier vecteur de données de batterie et du deuxième vecteur de données de batterie, d'un troisième vecteur de données de batterie,
dans lequel l'indicateur de santé de la batterie est basé en outre sur le troisième vecteur de données de batterie.

13. Procédé selon la revendication 11 ou 12, comprenant :

l'entrée du deuxième vecteur de sortie dans le premier réseau neuronal ; et/ou
l'entrée du premier vecteur de sortie dans le deuxième réseau neuronal.

14. Procédé selon l'une quelconque des revendications 11 à 13, comprenant :

l'obtention des données de batterie par la surveillance d'au moins une batterie parmi une pluralité de batteries interconnectées ; et
la formation du deuxième réseau neuronal pour estimer l'état de santé de la pluralité de batteries interconnectées en fonction des données de batterie.

15. Procédé selon l'une quelconque des revendications 10 à 14, comprenant :

l'obtention des données de batterie par la surveillance d'au moins une batterie parmi une pluralité de batteries interconnectées ; et
la formation du premier réseau neuronal pour estimer des données de batterie futures de la pluralité de batteries interconnectées en fonction des données de batterie.

FIG. 1

200 →

| 202 — | obtaining battery data from a battery monitor monitoring the battery |
|---|---|
| 204 — | training a first neural network to estimate future battery data based on the battery data |
| 206 — | transmitting battery data obtained from the battery monitor |
| 208 — | formatting the battery data as a battery data point |
| 210 — | storing the battery data point as an element of a first battery data vector of N elements |
| 212 — | inputting the first battery data vector into the first neural network |
| 214 — | formatting, by the first neural network, an first output vector of N elements |
| 216 — | outputting, by an output device, a health indicator of the battery |

FIG. 2

EP 4 095 537 B1

18

FIG. 3

EP 4 095 537 B1

400

402 ┌─────────────────────┐        ┌─────────────────────┐ 402
        │ input_1: InputLayer │        │ input_2: InputLayer │
        └─────────────────────┘        └─────────────────────┘

404 ┌─────────────────────┐        ┌─────────────────────┐ 404
        │   lstm_1: LSTM      │        │   lstm_2: LSTM      │
        └─────────────────────┘        └─────────────────────┘

406 ┌─────────────────────┐
        │    dot_1: Dot       │
        └─────────────────────┘

408 ┌─────────────────────┐
        │   lstm_3: LSTM      │
        └─────────────────────┘

410 ┌──────────────────────────────────────────────────────────┐
        │ time_distributed_1(dense_1): TimeDistributed(Dense)      │
        └──────────────────────────────────────────────────────────┘

FIG. 4

$$x_i = [i_1 \quad v_1 \quad m_1 \quad a_1 \quad r_1 \quad s_1]$$

FIG. 5

FIG. 6

EP 4 095 537 B1

$$x_i = \begin{bmatrix} [i_1 & v_1 & m_1 & a_1 & r_1 & s_1] \\ [i_2 & v_2 & m_2 & a_2 & r_2 & s_2] \\ \vdots & \vdots & \vdots & \vdots & \vdots & \vdots \\ [i_N & v_N & m_N & a_N & r_N & s_N] \end{bmatrix}, \; y_i = \begin{bmatrix} [r_{N+1} & s_{N+1}] \\ [r_{N+2} & s_{N+2}] \\ \vdots & \vdots \\ [r_M & s_M] \end{bmatrix}$$

FIG. 7

FIG. 8

$$x_i = \begin{bmatrix} \begin{bmatrix} i_{1,1} & v_{1,1} & m_{1,1} & a_{1,1} & r_{1,1} & i_{1,2} & v_{1,2} & m_{1,2} & a_{1,2} & r_{1,2} & \dots & i_{1,X} & v_{1,X} & m_{1,X} & a_{1,X} & r_{1,X} & s_1 \end{bmatrix} \\ \begin{bmatrix} i_{2,1} & v_{2,1} & m_{2,1} & a_{2,1} & r_{2,1} & i_{2,2} & v_{2,2} & m_{2,2} & a_{2,2} & r_{2,2} & \dots & i_{2,X} & v_{2,X} & m_{2,X} & a_{2,X} & r_{2,X} & s_2 \end{bmatrix} \\ \vdots \quad \vdots \quad \vdots \quad \vdots \quad \vdots \quad \vdots \quad \vdots \quad \vdots \quad \vdots \quad \vdots \quad \vdots \quad \vdots \quad \vdots \quad \vdots \quad \vdots \quad \vdots \quad \vdots \\ \begin{bmatrix} i_{N,1} & v_{N,1} & m_{N,1} & a_{N,1} & r_{N,1} & i_{N,2} & v_{N,2} & m_{N,2} & a_{N,2} & r_{N,2} & \dots & i_{N,X} & v_{N,X} & m_{N,X} & a_{N,X} & r_{N,X} & s_N \end{bmatrix} \end{bmatrix}$$

FIG. 9

$$y_i = \begin{bmatrix} \begin{bmatrix} i_{N+1,1} & i_{N+1,2} & \dots & i_{N+1,X} & s_{N+1} \end{bmatrix} \\ \begin{bmatrix} i_{N+2,1} & i_{N+2,2} & \dots & i_{N+2,X} & s_{N+2} \end{bmatrix} \\ \vdots \quad \vdots \quad \vdots \quad \vdots \quad \vdots \\ \begin{bmatrix} i_{M,1} & i_{M,2} & \dots & i_{M,X} & s_M \end{bmatrix} \end{bmatrix}$$

FIG. 10

EP 4 095 537 B1

$$x_i = \begin{bmatrix} [ir_1 & vr_1 & s_1] \\ [ir_2 & vr_2 & s_2] \\ \vdots & \vdots & \vdots \\ [ir_N & vr_N & s_N] \end{bmatrix}, \quad y_i = \begin{bmatrix} SOH_1 \\ SOH_2 \\ \vdots \\ SOH_N \end{bmatrix}$$

1100

1110

FIG. 11

FIG. 12

EP 4 095 537 B1

$$x_i = \begin{bmatrix} \begin{bmatrix} ir_1 & vr_1 & s_1 \end{bmatrix} \\ \begin{bmatrix} ir_2 & vr_2 & s_2 \end{bmatrix} \\ \vdots & \vdots & \vdots \\ \begin{bmatrix} ir_N & vr_N & s_N \end{bmatrix} \end{bmatrix} , \; y_i = \begin{bmatrix} SOH_N \\ SOH_N \\ \vdots \\ SOH_N \end{bmatrix}$$

1300

1310

FIG. 13

FIG. 14

FIG. 15

**EP 4 095 537 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021033680 A
- US 2020081070 A
- DE 102018220494
- US 2018095140 A
- CA 3117022